# EUROPEAN PATENT APPLICATION

(11) **EP 4 167 472 A1**
(43) Date of publication of application: **19.04.2023**
(21) Application number: 21742452.2
(22) Date of filing: 16.06.2021
(51) Int. Cl.: H02S 40/22

(54) **PHOTOVOLTAIC SOLAR INSTALLATION HAVING BIFACIAL PANELS**

(30) Priority: 16.06.2020 ES 202031275 U
(71) Applicant: Soltec Innovations S.L., 30500 Molina de Segura Murcia (ES)
(72) Inventor: GUERRERO PÉREZ, Javier, 30500 Murcia (ES); TORRANO CARRILLO, Francisco Javier, 30500 Murcia (ES); CARPIO OBRE, Francisco Javier, 30500 Murcia (ES); TERUEL HERNÁNDEZ, José Alfonso, 30500 Murcia (ES)
(74) Representative: Isern Patentes y Marcas S.L.
(86) International application number: PCT/ES2021/070443
(87) International publication number: WO 2021/255313

(57) **Abstract**

It comprises at least one solar tracker (3) with: a rotating structure, which supports bifacial photovoltaic solar panels (4), in order to provide the panels (4) with a solar tracking rotation around, at least, a non-azimuth axis of rotation; and a control unit which commands the tracker (3); and an albedo reflector (5) arranged on the ground (7) on one side or on both sides of the solar tracker (3) with respect to the non-azimuth axis of rotation, next to the tracker (3) itself, wherein the albedo reflector (5) in turn comprises a reflective membrane (6) which reflects albedo radiation towards the panels (4). It enables the albedo radiation to be optimally harnessed.

## Description

### Technical field and object of the invention

The present invention can be included within the field of solar energy, in particular solar installations for photovoltaic solar energy. More specifically, the object of the invention refers to a photovoltaic solar installation having bifacial panels, with solar tracking and capture of albedo radiation.

### Background

A bifacial photovoltaic solar panel incorporates photovoltaic solar cells capable of capturing radiation through the two faces thereof, which enables a greater capture of solar radiation, since the face not facing the sun can receive albedo radiation which is reflected on the ground.

### Description of the Invention

The present invention enables an increase in the albedo radiation captured by bifacial solar panels to be obtained, by means of incorporating a radiation reflector comprising a reflective flexible membrane intended to be assembled on the ground below the bifacial photovoltaic solar panels supported on a solar tracker.

In light of the foregoing, the present invention relates to a photovoltaic solar installation having bifacial panels, comprising at least one photovoltaic solar tracker which supports a series of bifacial panels. The tracker is anchored to the ground by means of supports, for example, aligned drives. The tracker comprises a rotating structure in order to provide the panels with a certain solar tracking rotation around a non-azimuth axis of rotation and, optionally, also around an azimuth axis of rotation; and a control unit which commands the tracker. The presence of bifacial panels enables albedo radiation reflected on the ground to be captured, as indicated above.

The invention is characterised in that it further includes an albedo reflector arranged on the ground on one side and on the other side of the tracker, next to the tracker itself, along the non-azimuth axis of rotation. Each albedo reflector comprises a reflective membrane which reflects the albedo radiation towards the face of the bifacial panels whereon the solar radiation is not directly incident. In this manner, since the membrane has a better reflective nature than the ground, by including the albedo reflector in the tracker, the amount of albedo radiation harnessed by the bifacial panels is increased.

The membrane can be arranged horizontally or with an inclination. Likewise, the membrane can be fastened to the ground and/or to the tracker. In particular, for the case of a horizontal arrangement, the installation can comprise ballasts on the perimeter of the membrane, or alternatively the perimeter of the membrane can be buried in the ground. Moreover, in the case of an inclined membrane, the membrane can comprise eyelets along at least a portion of the perimeter thereof, wherein the installation further comprises one or more cords which pass through one or more of the eyelets in order to fasten the membrane to vertical fastenings.

### Brief description of the figures

The foregoing and other advantages and features will be more fully understood from the following detailed description of exemplary embodiments with reference to the accompanying drawings, which should be considered by way of illustration and not limitation, wherein:
Figure 1 shows a plan view of a tracker of the installation of the invention, with the albedo reflectors.
Figure 2 shows a first example, with the membrane arranged horizontally.
Figure 3 shows a second example, with the membrane arranged inclined.
Figure 4 shows a schematic plan view of an example of fastening an inclined membrane by means of eyelets, cords and cables.
Figure 5 shows an example with a single continuous reflector on both sides of the tracker, in a horizontal arrangement.
Figure 6 shows an example with a single continuous reflector on both sides of the tracker, in an inclined arrangement.

### Detailed description of an exemplary embodiment

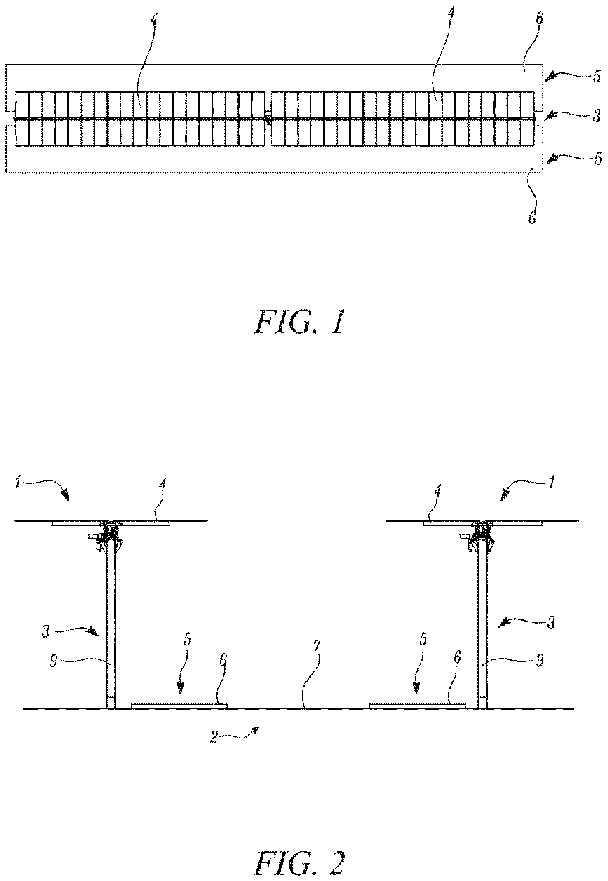

Next, a detailed description of a preferred exemplary embodiment of the photovoltaic solar installation having bifacial panels object of the present invention is provided, with the help of the aforementioned figures 1-6.

Figure 1 shows a detail of a photovoltaic solar installation, comprising several rows (1), see figure 2, separated by corridors (2), wherein in each row (1) several solar trackers (3) are arranged in an axis of non-azimuth rotation whereon bifacial photovoltaic solar panels (4) are assembled. The non-azimuth axis of rotation can have a horizontal or inclined direction. The installation further comprises two albedo reflectors (5), assembled next to each tracker (3), one on each side of the non-azimuth axis of rotation; wherein, for example, if the tracker (3) has a north-south non-azimuth axis of rotation, one of the albedo reflectors (5) is located to the east of the tracker (3) and the other to the west. Figure 2 shows two rows of panels (4) in each tracker (3), in other words, one row on one side of the tracker (3), for example, on the east side, if the non-azimuth axis of rotation is north-south, and the other row on the other side of the tracker (3), for example, on the west side, which corresponds to a configuration called "2P". The present invention is also applicable to the case of a configuration called "1 P", with a single row of panels (4) per tracker (3).

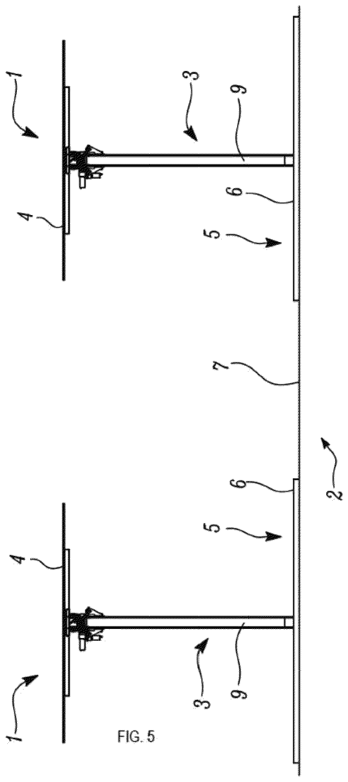

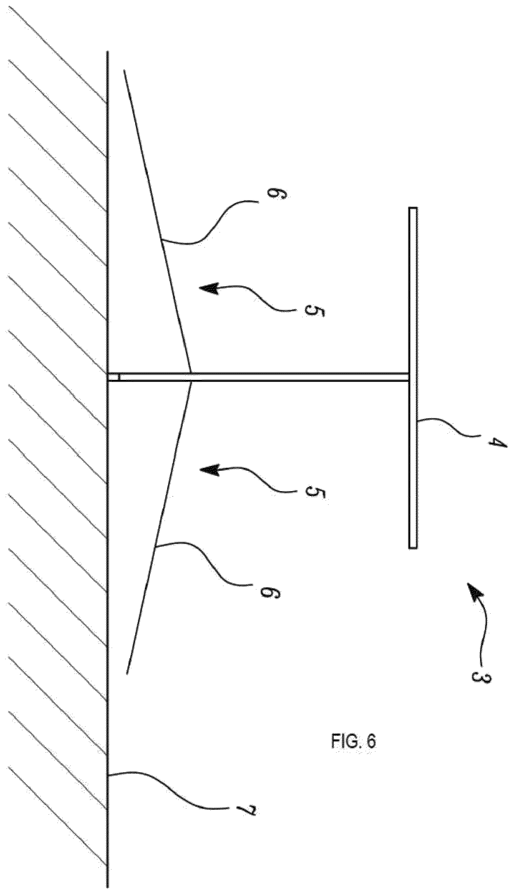

Moreover, the possibilities in number and distribution of the albedo reflectors (5) are: one single albedo reflector (5) arranged under the tracker (3); and two albedo reflectors (5), one on one side, such as the east side, and the other on the other side, such as the west side, of the trackers (3). The albedo reflectors (5), as explained below, can be spaced from the tracker (3), or they can be next to the tracker (3), at a distance of zero or, at least, a minimum distance. In the case of having two albedo reflectors (5) per tracker (3), not separated from the tracker (3), the albedo reflectors (5) can be joined together, forming a continuous reflector which simplifies the device, as observed in figure 5, for horizontal albedo reflectors, and in figure 6, for inclined albedo reflectors (5).

Each albedo reflector (5) comprises a membrane (6), preferably rectangular in shape. Each membrane (6) has a length dimension, along the non-azimuth axis of rotation, more specifically of the projection of the non-azimuth axis of rotation on the ground (7), related to the length of the tracker (3), as well as a width dimension, perpendicular to said projection, smaller than the length dimension, preferably between 1.5 m and 3 m. Preferably, the aforementioned dimensions of between 1.5 and 3 m correspond to 2P configurations, while, for 1P configurations, a width of around 1 m, for example, between 0.75 and 1.25 m, is preferred. The length and width dimensions are determined by taking into account a balance between the increase in albedo energy recovered, on the one hand, and the amount of material and space occupied, on the other hand.

Either geosynthetic materials, such as geomembranes, or technical textile materials are preferred for the membranes (6), as explained below.

Likewise, the membranes (6) have a white colour, in order to optimise the reflection of albedo.

Each membrane (6) is preferably arranged at a distance from the tracker (3), considered as the horizontal distance to the axis of the tracker (3), which is not greater than 75 cm, preferably between 40 cm and 50 cm, all of this in order to optimise the bifacial gain of albedo and to not occupy an excessive space in the corridor (2), which would prevent, for example, the circulation of vehicles for maintenance of the trackers (3) and the panels (4). Other shorter distances are possible; in particular, as explained above, the distance can even be zero, in which case, for two albedo reflectors (5) arranged for the same tracker (3), both albedo reflectors (5) can share a common anchor, for the purpose of simplifying the device without affecting the production.

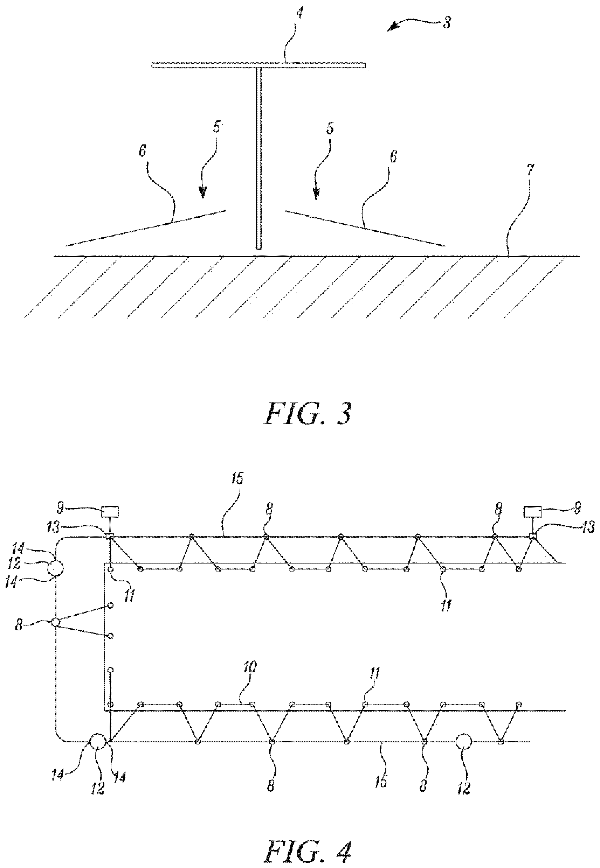

According to a first preferred embodiment, see figure 2, the membrane (6) of the albedo reflector or reflectors (5) is arranged horizontally, while, according to a second preferred embodiment, see figure 3, the membrane (6) is arranged inclined.

In the first embodiment, as illustrated in figure 2, with the membranes (6) arranged horizontally, a geosynthetic material, preferably a geomembrane, is used for the membranes (6). The geosynthetic material, in particular the geomembrane, can be made of different materials, such as polyethylene, both high and low density, elastomeric bitumen, polypropylene or polyvinyl chloride, among others. The membrane (6) can be composed of a matrix of the selected material, which incorporates additives, such as titanium oxide. A commercial example of a geomembrane is the Alvatech Geomembrane by Sotrafa. The length of the membrane (6) can be substantially equivalent to the complete length of the tracker (3), such as 30 m or 45 m, for example, or even exceed said total length of the tracker (3), as seen in figure 1. Moreover, with respect to the width, it has been determined that, starting from 2.5 m, the gain in capture of albedo radiation does not grow significantly with respect to the increase in the amount of material. Therefore, a width of 2.5 m is preferred, which corresponds to one of the standard width values wherein the material is served. Preferably, the aforementioned dimensions of 2.5 m correspond to 2P configurations, while, for 1P configurations, a width of around 1 m, for example, between 0.75 and 1.25 m, is preferred. The membranes (6) in a horizontal position can preferably be arranged flush with the ground (7). The albedo reflectors (5) can be fastened to the ground (7) in several ways. For the present horizontal case, depositing ballasts, such as sandbags, on the perimeter of the membranes (6) is preferred. Alternatively, the membranes (6) may have the perimeter buried in the ground (7).

Moreover, in the second embodiment, as shown in figure 3 and in figure 6, with the inclined membranes (6), membranes (6) made of technical textile material, formed by a textile armour and a polymeric coating, are preferred. As preferred examples of technical textile materials, the following may be cited: Flexlight Advanced 902 Technical Textile from Serge Ferrari; and Technical Textile 501,700 from Protan. The length of the membrane (6) does not need to reach the total length of the tracker (3), but can be limited to the length existing between supports (9), such as drives, ends which, for example, for a tracker (3) 45 m, would be 42 m. Regarding the width, it has been determined that the most optimal values for the ratio between albedo energy recovery and amount of material and occupied space are produced with a width of between 2 m and 2.5 m, the results being equivalent for both cases, and both cases further corresponding to standard values wherein the material is served, for which reason the width of 2 m is preferred, in order to optimise cost and use of space. Likewise, an inclination of no less than 20% is preferred, with the highest portion arranged closer to the tracker (3), in order to facilitate evacuation of water. Preferably, the aforementioned dimensions of 2-2.5 m correspond to 2P configurations, while, for 1P configurations, a width of around 1 m, for example, between 0.75 and 1.25 m, is preferred.

In general, for all the described embodiments, a preferred example envisages the albedo reflectors (5) having width dimensions of around 5/8 of the width dimension of the tracker, in other words, between 0.6 and 0.65 times the width of the tracker.

As illustrated in figure 4, in order to fasten the membranes (6) arranged inclined to the ground (7), the use of cords (10), preferably elastic, is preferred. The membrane (6) has eyelets (11) arranged, preferably in a regular manner, along at least a portion of the perimeter, preferably the entire perimeter. In this manner, one or more cords (10) pass through at least one of the eyelets (11) in order to fasten the membrane (6) to vertical fastenings (9, 12), which can be either the supports (9) themselves, such as the drives, and/or posts (12) driven into the ground (7) around the membrane (6), for example, piles, driven metal profiles, screwed bolts, etc.

According to what was explained above, several possibilities for fastening the membrane (6) in the inclined case are indicated below.

The supports (9), such as the drives, can include first retention elements (13), such as hoops, fastened to the supports (9), by welding or by threading or by any other method, as shown in figure 4, or orifices (according to an alternative example not shown), in order to retain the cord (10) or the cords (10). Moreover, the posts (12) can include second retention elements (14), in order to retain the cord (10) or the cords (10), such as first holes in the upper portion, in order to enable the passage of the cord (10) or the cords (10). In this manner, each cord (10) can be passed through one or more eyelets (11) and be connected to the fastening element (13, 14) of one or more vertical fastenings (12, 9). According to a preferred example, shown in figure 4, a single cord (10) runs like a seam through all the eyelets (11) and in the course thereof is connected to the retention means (13, 14), for example, to the hoops of the drives and to the first holes of the posts (12).

For any of the previous examples, at least one cable (15) which runs along the vertical fastenings (9, 12) can further be included, as seen in figure 4. The cable (15) or the cables (15) may incorporate tensioners (not shown). More preferably, there may be a single cable (15) which runs along the perimeter of all the vertical fastenings (9, 12), or there may be several cables (15), wherein one or more of them run along the supports (9), and wherein the other or others run along the posts (12). For either of the two options, in the case of the supports (9), the cable (15) or the cables (15) can be housed in the first fastening elements (13), such as the hoops. In the case of the posts (12), they may have second holes (not shown) crossed through by the cable (15) or the cables (15). In the case of using the cable (15) or cables (15), carabiners (8) can be included in order to connect the cable (15) or the cables (15) with the cord (10) or the cords (10) in intermediate positions between vertical fastenings (9, 12).

## Claims

1. A photovoltaic solar installation having bifacial panels, comprising at least one solar tracker (3) with:
- a rotating structure, which supports bifacial photovoltaic solar panels (4), in order to provide the panels (4) with a solar tracking rotation around, at least, one non-azimuth axis of rotation; and
- a control unit which commands the tracker (3);
**characterised in that** it additionally comprises an albedo reflector (5) arranged on the ground (7), on one side or on both sides of the solar tracker (3) with respect to the non-azimuth axis of rotation, next to the tracker (3) itself,
wherein the albedo reflector (5) in turn comprises a reflective membrane (6) which reflects albedo radiation towards the panels (4).

2. The photovoltaic solar installation according to claim 1, **characterised in that** the membrane (6) is white in colour.

3. The photovoltaic solar installation according to any of claims 1-2, **characterised in that** the membrane (6) is made of geosynthetic material or of technical textile material.

4. The photovoltaic solar installation according to any of claims 1-3, **characterised in that** the membrane (6) has a rectangular shape, with a length dimension, along the projection of the non-azimuth axis of rotation on the ground (7), and a width dimension, perpendicular to said projection, and smaller than the length dimension.

5. The photovoltaic solar installation according to any of claims 1-4, **characterised in that** the tracker (3) has a 1P configuration, with one single row of panels (4) or 2P configuration, with two rows of panels, one on one side and the other on the other side of the tracker (3).

6. The photovoltaic solar installation according to claim 5, **characterised in that** the width dimension comprises between 1.5 m and 3 m.

7. The photovoltaic solar installation according to any of claims 1-6, **characterised in that** the membrane (6) is arranged at a distance from the tracker (3) no greater than 75 cm.

8. The photovoltaic solar installation according to claim 7, **characterised in that** the membrane (6) is arranged at a distance from the tracker (3) of between 40 cm and 50 cm.

9. The photovoltaic solar installation according to claim 8, **characterised in that** the membrane (6) is arranged without horizontal distance to the axis of the tracker (3).

10. The photovoltaic solar installation according to any of claims 1-9, **characterised in that** the membrane (6) is arranged horizontally.

11. The photovoltaic solar installation according to claim 3, **characterised in that** the membrane (6) is made of geosynthetic material.

12. The photovoltaic solar installation according to claim 11, **characterised in that** the membrane (6) is made of geomembrane material.

13. The photovoltaic solar installation according to any of claims 11-12, **characterised in that** the membrane (6) includes titanium oxide.

14. The photovoltaic solar installation according to any of claims 10-13, **characterised in that** the membrane (6) has a length dimension which completely encompasses the tracker (3).

15. The photovoltaic solar installation according to any of claims 10-14, **characterised in that** the width dimension of the membrane (6) is 2.5 m.

16. The photovoltaic solar installation according to any of claims 10-15, **characterised in that** the membrane (6) is arranged flush with the ground (7).

17. The photovoltaic solar installation according to any of claims 10-16, **characterised in that** it comprises ballasts on the perimeter of the membrane (6) in order to fasten the membrane (6) to the ground.

18. The photovoltaic solar installation according to any of claims 10-16, **characterised in that** the membrane (6) has the perimeter buried in the ground (7), in order to fasten the membrane (6) to the ground (7).

19. The photovoltaic solar installation according to any of claims 1-8, **characterised in that** the membrane (6) is arranged inclined on the ground (7).

20. The photovoltaic solar installation according to claim 19, **characterised in that** the membrane (6) is made of a technical textile material, formed by a textile armour and a polymeric coating.

21. The photovoltaic solar installation according to any of claims 19-20, **characterised in that** the tracker (3) has supports (9) aligned according to the projection of the non-azimuth axis of rotation,
wherein the length of the membrane (6) encompasses the length between end supports (9) of the tracker (3).

22. The photovoltaic solar installation according to any of claims 18-20, **characterised in that** the width of the membrane (6) is 2 m.

23. The photovoltaic solar installation according to any of claims 19-22, **characterised in that** the membrane (6) is inclined at least 20%, with the highest portion arranged closer to the tracker (3).

24. The photovoltaic solar installation according to any of claims 19-23, **characterised in that** the membrane (6) comprises eyelets (11) along at least a portion of the perimeter thereof, wherein the installation further comprises one or more cords (10) which pass through one or more of the eyelets (11) in order to fasten the membrane (6) to vertical fastenings (9, 12).

25. The photovoltaic solar installation according to claim 24, **characterised in that** the vertical fastenings (9, 12) comprise the supports (9).

26. The photovoltaic solar installation according to claim 25, **characterised in that** the supports (9) comprise first retention means (13), fastened to said supports (9) in order to retain the cord (10) or the cords (10).

27. The photovoltaic solar installation according to claim 26, **characterised in that** the first retention means (13) comprise hoops.

28. The photovoltaic solar installation according to claim 27, **characterised in that** the cord (10) or the cords (10) are housed in the hoops.

29. The photovoltaic solar installation according to any of claims 24-28, **characterised in that** the vertical fastenings (9, 12) comprise posts (12) driven into the ground (7) around the membrane (6).

30. The photovoltaic solar installation according to claim 29, **characterised in that** the posts (12) comprise second retention means (14) in order to retain the cord (10) or the cords (10).

31. The photovoltaic solar installation according to claim 30, **characterised in that** the second retention means (14) comprise first holes in order to enable the passage of the cord (10) or the cords (10).

32. The photovoltaic solar installation according to any of claims 24-31, **characterised in that** it comprises a single cord (10) which runs like a seam along all the eyelets (11) and in the course thereof is connected to the retention means (13, 14).

33. The photovoltaic solar installation according to any of claims 24-32, **characterised in that** it additionally comprises at least one cable (15) which runs along the vertical fastenings (9, 12).

34. The photovoltaic solar installation according to claim 33, **characterised in that** the cable (15) or the cables (15) are housed in the first fastening elements (13) of the supports (9).

35. The photovoltaic solar installation according to any of claims 33-34, **characterised in that** the posts (12) have second holes (16) crossed through by the cable (15) or the cables (15).

36. The photovoltaic solar installation according to claims 34 and 35, **characterised in that** it additionally includes carabiners (8) in order to connect the cable (15) or the cables (15) with the cord (10) or the cords (10) in intermediate positions between vertical fastenings (9, 12).

37. The photovoltaic solar installation according to any of claims 1-36, **characterised in that** the membrane (6) has a width of between 0.60 and 0.65 times the width of the tracker (3).
